# EUROPEAN PATENT APPLICATION

(11) **EP 4 693 372 A1**
(43) Date of publication of application: **11.02.2026**
(21) Application number: 24779144.5
(22) Date of filing: 05.03.2024
(51) Int. Cl.: H01L 21/30, B29C 59/02

(54) **LAMINATED BODY, IMPRINT MOLD, METHOD FOR MANUFACTURING IMPRINT MOLD, METHOD FOR MANUFACTURING OPTICAL ELEMENT, AND METHOD FOR MANUFACTURING ELECTRONIC COMPONENT**

(30) Priority: 24.03.2023 JP 2023048976
(71) Applicant: Hoya Corporation, Tokyo 160-8347 (JP)
(72) Inventor: AIZAWA, Takeshi, Tokyo 160-8347 (JP); IKENISHI, Mikio, Tokyo 160-8347 (JP)
(74) Representative: Vossius & Partner Patentanwälte Rechtsanwälte mbB
(86) International application number: PCT/JP2024/008180
(87) International publication number: WO 2024/203006

(57) **Abstract**

Provided is a laminated body that is suitably used as a blank for an imprint mold capable of obtaining a desired uneven shape with high accuracy without complicating a design process and a manufacturing process. The laminated body 10 comprises: a substrate 1 that contains at least one of CaO, La₂O₃, Nb₂O₅, and BaO; a functional layer 2 that is provided on the substrate 1; and an etching mask layer 3 that is provided on the functional layer 2.

## Description

### TECHNICAL FIELD

The present invention relates to an imprint mold applied to fabrication of a fine circuit pattern of an electronic component such as a semiconductor device, fabrication of an optical element with an optical function added by a fine pattern, and so on, a method for manufacturing the imprint mold, and a stacked body suitably used as an imprint mold blank in manufacture of the imprint mold.

### BACKGROUND ART

In fabrication of a fine circuit pattern of an electronic component such as a semiconductor device or formation of a fine pattern in fabrication of an optical component (such as a diffraction grating) with an optical function added by the fine pattern, an imprinting method for transferring the same fine pattern in large quantities has become used.

The imprinting method is a method including using, as an original plate, an imprint mold (stamper) provided with a fine mold pattern, directly pressing the imprint mold against, for example, a liquid resin, such as a photocurable resin, which is a transfer target applied on a substrate, and curing the liquid resin by ultraviolet light or the like to thereby transfer the mold pattern to the cured liquid resin. Therefore, according to the imprinting method, the same fine pattern can be transferred in large quantities.

As described above, the imprint mold serves as the original plate for transferring the same fine pattern in large quantities. Therefore, a dimensional accuracy of the mold pattern formed on the mold directly affects a dimensional accuracy of the fine pattern to be fabricated. In addition, the imprint mold is directly pressed against the liquid resin applied on the substrate to transfer the pattern. Accordingly, a cross-sectional shape of the mold pattern significantly affects a shape of the fine pattern to be fabricated. With an improvement of an integration degree of a semiconductor device or the like, a desired pattern size is reduced and pattern transfer is performed at the same magnification. Therefore, the imprint mold of a higher accuracy has become required.

Heretofore, in the fabrication of the imprint mold, it is known to dig into a substrate by etching using, as a mask, a thin film pattern formed on the substrate of synthetic quartz or the like (for example, Patent Literature 1). Thus, a desired concave-convex shape can be formed on the substrate to obtain the imprint mold.

As an imprinting substrate for fabrication of the imprint mold, there is known a structure including a substrate of synthetic quartz or the like and a plurality of films, stacked on the substrate, each comprising two layers (two-layer films) having etching selectivity with respect to each other (for example, Patent Literature 2).

### PRIOR ART LITERATURE(S)

### PATENT LITERATURE(S)

Patent Literature 1: JP 2011-227950 A
Patent Literature 2: JP H6-258510 A

### SUMMARY OF THE INVENTION

### PROBLEM TO BE SOLVED BY THE INVENTION

However, in the fabrication of the imprint mold as disclosed in Patent Literature 1, it is not easy to control the amount of digging into the substrate (digging depth) with high accuracy. In addition, it is not easy to accurately form recesses obtained by digging into the substrate into a desired shape or to make the recesses uniform in a substrate plane.

On the other hand, with the imprinting substrate for fabrication of the imprint mold as disclosed in Patent Literature 2, adjusting a film thickness of the two-layer film makes it unnecessary to precisely control the digging depth during etching. However, in a case where the imprinting substrate is fabricated, it is necessary not only to stack a number of two-layer films depending on the number of recesses different in digging depth but also to design a film thickness of each layer depending on a desired digging depth and to form each layer by adjusting the film thickness each time. Therefore, a design process and a manufacturing process of the imprinting substrate become very complicated. As a material of an upper layer in the two-layer film, a material having low etching selectivity with respect to the substrate, for example, SiO₂, is used. Therefore, upon etching the upper layer in the two-layer film in contact with the substrate, a lower layer serves to protect the substrate as an etching stopper film. However, at a bottom of the recess having the largest digging depth in the imprint mold, the lower layer is removed by etching and the substrate is exposed. When the lower layer is etched, the substrate is inevitably damaged. This causes a trouble that a desired concave-convex shape cannot be obtained with high accuracy.

The present invention has been made in view of the above-mentioned conventional problems described above. It is a first object of the present invention to provide a stacked body suitably used as an imprint mold blank capable of obtaining a desired concave-convex shape with high accuracy, without complicating a design process or a manufacturing process. It is a second object to provide an imprint mold manufactured using the above-mentioned stacked body and a method for manufacturing the imprint mold. It is a third object to provide a method for manufacturing an optical element and a method for manufacturing an electronic component, in which the above-mentioned imprint mold is used.

### MEANS FOR SOLVING THE PROBLEM

As a result of intensive studies of the present inventors, the present invention has the following configurations in order to solve the above-mentioned problems.

### (Configuration 1)

A stacked body including a substrate containing at least one of CaO, La₂O₃, Nb₂O₅, and BaO, a functional layer formed on the substrate, and an etching mask layer formed on the functional layer.

### (Configuration 2)

The stacked body according to Configuration 1, wherein the functional layer is in contact with the substrate.

### (Configuration 3)

The stacked body according to Configuration 1, wherein a total content of CaO, La₂O₃, Nb₂O₅, and BaO contained in the substrate is 30 mass% or more.

### (Configuration 4)

The stacked body according to Configuration 1, wherein the functional layer is made of a material containing silicon and at least one of oxygen and nitrogen.

### (Configuration 5)

The stacked body according to Configuration 1, wherein, in a state where the functional layer is stacked on the substrate, a transmittance of light having a wavelength of 365 nm transmitted through the substrate and the functional layer is 50% or more.

### (Configuration 6)

The stacked body according to Configuration 1, wherein the etching mask layer contains one or more selected from chromium, tantalum, zirconium, hafnium, and tungsten.

### (Configuration 7)

A method for manufacturing an imprint mold, including the steps of: preparing the stacked body according to any one of Configurations 1 to 6; forming an etching mask pattern on the etching mask layer; etching the functional layer using the etching mask pattern as a mask; and removing the etching mask pattern.

### (Configuration 8)

An imprint mold including a substrate containing at least one of CaO, La₂O₃, Nb₂O₅ and BaO, and a functional layer formed on the substrate, wherein the functional layer has a plurality of recesses constituting a predetermined mold pattern.

### (Configuration 9)

The imprint mold according to the Configuration 8, wherein the functional layer is in contact with the substrate.

### (Configuration 10)

The imprint mold according to Configuration 8, wherein a total content of CaO, La₂O₃, Nb₂O₅, and BaO contained in the substrate is 30 mass% or more.

### (Configuration 11)

The imprint mold according to Configuration 8, wherein the functional layer is made of a material containing silicon and at least one of oxygen and nitrogen.

### (Configuration 12)

The imprint mold according to Configuration 8, wherein, in a state where the functional layer is stacked on the substrate, a transmittance of light having a wavelength of 365 nm transmitted through the substrate and the functional layer is 50% or more.

### (Configuration 13)

The imprint mold according to Configuration 8, wherein each recess has a bottom which is an exposed part of the substrate.

### (Configuration 14)

A method for manufacturing an optical element, including the steps of: preparing an imprint mold manufactured using the stacked body according to any one of Configurations 1 to 6 or preparing the imprint mold according to any one of Configurations 8 to 13; curing a transfer target applied to an optical element substrate in a state where the imprint mold is pressed against the transfer target; and separating the imprint mold from the transfer target.

### (Configuration 15)

A method for manufacturing an electronic component, including the steps of: preparing an imprint mold manufactured using the stacked body according to any of Configurations 1 to 6 or preparing the imprint mold according to any of Configurations 8 to 13; curing a transfer target applied to an electronic component substrate in a state where the imprint mold is pressed against the transfer target; and separating the imprint mold from the transfer target.

### EFFECTS OF THE INVENTION

According to the present invention, it is possible to provide a stacked body suitably used as an imprint mold blank capable of obtaining a desired concave-convex shape with high accuracy without complicating a design process or a manufacturing process.

Further, according to the present invention, it is possible to provide an imprint mold having a mold pattern with high accuracy, manufactured using the stacked body, and a method for manufacturing the imprint mold.

Further, according to the present invention, it is possible to provide a method for manufacturing an optical element and a method for manufacturing an electronic component, each of the optical element and the electronic component, having a fine pattern with high accuracy, formed by using the above-mentioned imprint mold.

### BRIEF DESCRIPTION OF THE DRAWINGS

FIG. 1 is a cross-sectional view showing a layer configuration of a stacked body according to one embodiment of the present invention;
FIG. 2 is a cross-sectional view showing an imprint mold according to one embodiment of the present invention;
FIGS. 3(a) to 3(i) are cross-sectional views for explaining an imprint mold manufacturing process according to a first embodiment;
FIGS. 4(j) to 4(p) are cross-sectional views showing a continuation of the manufacturing process in FIG. 3;
FIGS. 5(a) to 5(i) are cross-sectional views for explaining an imprint mold manufacturing process according to a second embodiment of the present invention;
FIGS. 6(j) to 6(o) are cross-sectional views showing a continuation of the manufacturing process in FIG. 5;
FIGS. 7(a) to 7(i) are cross-sectional views for explaining an imprint mold manufacturing process according to a third embodiment of the present invention;
FIGS. 8(j) to 8(o) are cross-sectional views showing a continuation of the manufacturing process in FIG. 7; and
FIGS. 9(a) to 9(c) are cross-sectional views for explaining pattern transfer to a transfer target by imprinting.

### MODE FOR CARRYING OUT THE INVENTION

Hereinafter, mode for carrying out the present invention will be described in detail with reference to the drawings.

### [Stacked body]

First, a stacked body of the present invention will be described. The stacked body according to the present invention is suitably used as an imprint mold blank when manufacturing an imprint mold.

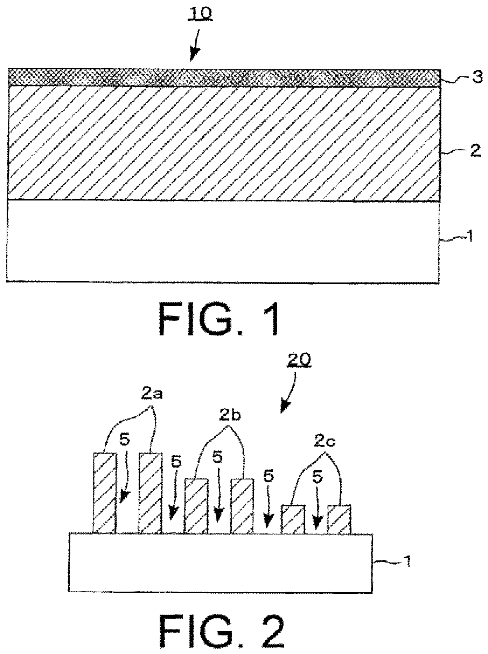

FIG. 1 is a cross-sectional view showing a layer configuration of a stacked body according to one embodiment of the present invention.

As shown in FIG. 1, the stacked body 10 according to one embodiment of the present invention includes a substrate 1, a functional layer 2 formed on the substrate 1, and an etching mask layer 3 formed on the functional layer 2.

In the present invention, the substrate 1 has two main surfaces which face away from each other and four end faces. The substrate 1 is a substrate containing at least one of CaO, La₂O₃, Nb₂O₅, and BaO. In particular, the substrate 1 is preferably a glass substrate in which a total content of CaO, La₂O₃, Nb₂O₅ and BaO is 30 mass% or more.

As will later be described in detail, when the imprint mold is manufactured using the stacked body, the functional layer 2 is etched by using a fluorine-containing gas until a surface of the substrate 1 is exposed to thereby form a recess of a desired shape. In this step, in the substrate 1, a processing damage due to etching is reduced to be negligibly small as compared with, for example, a synthetic quartz substrate of SiO₂. In addition, since the substrate 1 also has high resistance to a chlorine-based gas, the processing damage of the substrate 1 in a recess forming step using the chlorine-based gas can be reduced to be negligibly small. As a result, the recess obtained by digging the functional layer 2 by etching can accurately be formed into a desired shape.

A refractive index n_{d} of the substrate 1 with respect to a d line (wavelength 587.56 nm) is preferably 1.5 or more, more preferably 1.7 or more. The refractive index n_{d} is preferably 2.5 or less, more preferably 2.3 or less, further preferably 2.2 or less. An Abbe number v_{d} of the substrate 1 is preferably 60 or less, more preferably 50 or less, further preferably 40 or less. The Abbe number v_{d} is preferably 10 or more, more preferably 15 or more.

The Abbe number v_{d} can be calculated by v_{d} = (n_{d} -1)/(n_{F} - n_{C}). Here, n_{F} means a refractive index of the substrate 1 with respect to an F line (wavelength 486.13 nm), and n_{C} means a refractive index of the substrate 1 with respect to a C line (wavelength 656.27 nm).

Next, the functional layer 2 will be described. The functional layer 2 is preferably formed on one main surface of the substrate 1 in contact with the substrate 1. That is, it is preferable that no other layer or film is interposed between the functional layer 2 and the substrate 1.

Further, the functional layer 2 preferably is a single layer. When the functional layer 2 is the single layer, the recess obtained by digging the functional layer 2 by etching can be formed into a desired shape (cross-sectional shape) having no steps in between.

The functional layer 2 preferably has a uniform composition in a film thickness direction except an interface with the substrate 1 (for example, within a range of 5 nm thickness from the substrate 1) and an interface with the etching mask layer 3 (for example, within a range of 5 nm thickness from the etching mask layer 3). When the functional layer 2 has the uniform composition in the film thickness direction except the interfaces with the substrate 1 and the etching mask layer 3, the recess obtained by digging the functional layer 2 by etching can be formed into a desired cross-sectional shape having no steps in between, and also an etching condition of the functional layer 2 is easily controlled. As long as the cross-sectional shape of the recess can be improved, the composition of the functional layer 2 may vary continuously or stepwise in the film thickness direction.

In the present invention, the functional layer 2 may be made of a material etchable with a fluorine-containing gas. For the functional layer 2, such material etchable with the fluorine-containing gas can be used without any particular limitation. The fluorine-containing gas may include F₂ gas, a perfluorocarbon gas such as CF₄, a hydrofluorocarbon gas such as CFH₃, SF₆ gas, NF₃ gas, SiF₄ gas, and HF gas. The fluorine-containing gas may further include a noble gas and/or oxygen. Although the noble gas is not particularly limited, for example, argon (Ar) may be used. Etching by the fluorine-containing gas is preferable because anisotropy is high and the shape of the recess can be improved.

The material etchable with the fluorine-containing gas may be, for example, a silicon-containing material. As the silicon-containing material, a material containing silicon and at least one of oxygen and nitrogen is particularly preferable. Specific examples of the silicon-containing material include SiO₂, SiNₓ, Si₃N₄, SiON, and so on. Further, a titanium-containing material is also preferable. A specific example of the titanium-containing material may be, for example, TiO₂. In addition, a material containing niobium (Nb), such as Nb₂O₅, may be used.

Since the substrate 1 has high resistance to a chlorine-containing gas, the functional layer 2 may also be made of a material etchable with the chlorine-containing gas. For the substrate 1, the material etchable with the chlorine-containing gas may be used without any particular limitation. As the substrate 1, an aluminum-containing material or a hafnium-containing material may be used. The aluminum-containing material includes Al₂O₃, aluminum silicate (AlₓSi_{y}O), and so on. The hafnium-containing material includes HfO, HfSiO, HfAlO, and so on, and a composition ratio is appropriately adjusted.

When the functional layer 2 is etched with the fluorine-containing gas, an etching selectivity ratio of the functional layer 2 with respect to the substrate 1 is preferably 2.5 or more, more preferably 3.0 or more, further preferably 3.5 or more.

In order to prevent damage of the functional layer 2 as a lower layer when the etching mask layer 3 formed on the functional layer 2 is patterned by etching, the functional layer 2 is preferably resistant to the etching condition of the etching mask layer 3. As will later be described, a chromium-containing material is preferably used as the etching mask layer 3. As an etching gas at the time of patterning the etching mask layer 3 made of the chromium-containing material, a chlorine-containing gas (e.g. Cl₂, SiCl₂, CHCl₃, CH₂Cl₂, CCl₄, BCl₃) or a mixed gas of oxygen and at least one of the above chlorine-containing gases is normally used. Therefore, when the etching mask layer 3 is made of the chromium-containing material, the functional layer 2 is preferably resistant to the chlorine-containing gas (e.g. Cl₂, SiCl₂, CHCl₃, CH₂Cl₂, CCl₄, BCl₃) or the mixed gas of oxygen and the at least one of the above chlorine-containing gases.

The silicon-containing material and the titanium-containing material, for example, referred to as the preferable material of the functional layer 2 are also resistant to the above chlorine-containing gases and the mixed gas of oxygen and the above chlorine-containing gases.

A film thickness of the functional layer 2 is not particularly limited. In short, when the imprint mold is manufactured using the stacked body 10 of the present invention, it is only necessary to design the film thickness of the functional layer 2 depending on a digging depth of the recess formed by digging the functional layer 2 by etching and/or a height of a protruding portion which will later be described, and to form the functional layer 2.

A method of forming the functional layer 2 on the substrate 1 is not particularly limited. Among others, sputtering film formation is preferable. The sputtering film formation is advantageous because a uniform film having a constant film thickness can be formed.

When a mold pattern is transferred to a transfer target (transfer object) using the imprint mold as an original plate, a resin (transfer target) applied to, for example, an optical element substrate is cured in a state where the imprint mold is pressed against the resin. In this step, the resin is generally cured by light irradiation or heating. In particular, in a case of the light irradiation from an imprint mold side, the imprint mold must have light transmissibility. Therefore, when the light irradiation is performed from the imprint mold side, the transmittance of light having a wavelength of, for example, 365 nm transmitted through the substrate 1 and the functional layer 2 is preferably 50% or more, more preferably 70% or more, in a state where the functional layer 2 is stacked on the substrate 1

Next, the etching mask layer 3 will be described. The etching mask layer 3 is preferably formed on the functional layer 2 in contact with the functional layer 2. That is, it is preferable that no other layer or film is interposed between the etching mask layer 3 and the functional layer 2.

The etching mask layer 3 has a function as a hard mask film upon etching (digging) the functional layer 2 for forming a mold pattern in the functional layer 2. Therefore, as the etching mask layer 3, a material is selected which has etching selectivity with respect to the functional layer 2 under an etching condition of the functional layer 2 to form the mold pattern in a subsequent step. As described above, the functional layer 2 is etched with the fluorine-containing gas or the chlorine-containing gas. Therefore, it is preferable that the etching mask layer 3 is resistant to the etching condition. In the present invention, the etching mask layer 3 is preferably formed of, for example, a material containing one or more selected from chromium, tantalum, zirconium, hafnium, and tungsten. When the functional layer 2 is etched with the chlorine-containing gas, the etching mask layer 3 is preferably formed of a material etchable with the fluorine-containing gas, and may be formed of, for example, a silicon-containing material such as SiO₂, SiON, SiNₓ, and Si₃N₄.

The etching mask layer 3 is preferably formed of, for example, a chromium-containing material. When the fluorine-containing gas is used for dry etching of the functional layer 2, the chromium-containing material has etching selectivity with respect to the functional layer 2 for the fluorine-containing gas. In addition, the chromium-containing material is preferable because it is easily etchable with the chlorine-containing gas and is excellent in workability.

The chromium (Cr)-containing material (chromium-based material) includes chromium metal, chromium nitride, chromium carbide, chromium carbonitride, and chromium oxycarbonitride. In this case, the etching mask layer 3 can be etched with the chlorine-containing gas. Preferably, a metal most abundant in the chromium-based material is chromium. The metal contained in the chromium-based material preferably contains 5 atomic% or less of metal other than chromium, and more preferably contains no other metal than chromium. An etching rate upon etching the chromium-based material with the chlorine-containing gas is higher than an etching rate upon etching the silicon-containing material with the fluorine-containing gas. Therefore, by using the chromium-based material as the etching mask layer 3, productivity can be improved.

Other materials than the chromium-containing material may be, for example, a material containing tantalum, zirconium, hafnium, tungsten, or the like (single metal; alloy; oxide, nitride, carbide, oxynitride, carbonitride, or oxynitride carbide of single metal as well as oxide, nitride, carbide, oxynitride, carbonitride, or oxynitride carbide of alloys). The tantalum-containing material is preferable because it is easily etchable with the chlorine-containing gas and/or the fluorine-containing gas and is excellent in workability.

Such an etching mask layer 3 may be formed of a single layer or a plurality of layers. For example, the etching mask layer 3 may be a single-layer film of the chromium-based material. Also, for example, the etching mask layer 3 may be a stacked film of at least an upper layer and a lower layer, wherein the upper layer is formed of the chromium-based material and the lower layer is formed of a material containing tantalum (Ta) as a main component. In this case, the material containing tantalum as the main component may be, for example, a Ta compound such as TaHf, TaZr, and TaHfZr, or a material containing the Ta compound as a base material and a subsidiary material, such as B, Ge, Nb, Si, C, N, or the like added thereto. The material containing tantalum as the main component is suitable because it is possible to provide a function of securing necessary conductivity so as to enable charge-up prevention during electron beam drawing upon forming a resist pattern on the etching mask layer 3 and mold pattern inspection by a scanning electron microscope (SEM). The etching mask layer 3 may be a composition gradient film in which its composition continuously or stepwise changes in the film thickness direction.

Needless to say, those exemplary configurations and materials of the etching mask layer 3 are mere examples, and the present invention is not limited thereto.

A film thickness of the etching mask layer 3 is not particularly limited, but may be, for example, 2 nm or more and 80 nm or less, more preferably 70 nm or less, further preferably 60 nm or less. By setting the film thickness of the etching mask layer 3 to 2 nm or more, when the functional layer 2 is etched using a pattern of the etching mask layer 3 as a mask during formation of the mold pattern, the pattern of the etching mask layer 3 can remain sufficiently until completion of the etching. The film thickness of the etching mask layer 3 is more preferably 5 nm or more, further preferably 10 nm or more. On the other hand, by setting the film thickness of the etching mask layer 3 to 80 nm or less, a shape of a fine pattern can be improved. In addition, the etching mask layer 3 can be finally removed without damaging the material of the functional layer 2.

A method of forming the etching mask layer 3 on the functional layer 2 is not particularly limited. Among others, sputtering film formation is preferable. The sputtering film formation is advantageous because a uniform film having a constant film thickness can be formed.

The stacked body 10 according to one embodiment of the present invention may have a configuration in which a resist film described later is formed on the etching mask layer 3.

### [Imprint Mold]

Next, the imprint mold according to the present invention will be described.

FIG. 2 is a cross-sectional view showing the imprint mold according to one embodiment of the present invention.

The imprint mold 20 according to one embodiment of the present invention illustrated in FIG. 2 is manufactured using the above-described stacked body 10 as the imprint mold blank.

Specifically, the imprint mold 20 includes a substrate 1 and functional layers 2a, 2b, and 2c formed on the substrate 1 and having a plurality of recesses 5 constituting a predetermined mold pattern. At a bottom of each of the recesses 5, a main surface of the substrate 1 is exposed. In the imprint mold 20 of the present embodiment, the functional layers 2a, 2b, and 2c are different in height from the main surface of the substrate 1 as illustrated in the figure. In short, the imprint mold 20 according to the present embodiment includes the substrate 1 and the functional layers 2a, 2b, and 2c formed on the substrate 1 and having a convex-concave structure with different heights constituting the predetermined mold pattern. The functional layers 2a, 2b, and 2c have a shape protruding from the main surface of the substrate 1, and may collectively be referred to as protrusions. The imprint mold 20 may have a plurality of protrusions different in height from each other. An upper surface of each protrusion may be parallel to the main surface of the substrate 1. The upper surface of the protrusion refers to a surface, of each of the functional layers 2a, 2b, and 2c, which faces away from a surface thereof in contact with the substrate 1. Being parallel to the main surface of the substrate 1 means that a plane A determined by the least squares method with respect to the upper surface of the protrusion is parallel or substantially parallel to a plane B determined by the least squares method with respect to the main surface of the substrate 1. Being substantially parallel means that an angle formed by the plane A and the plane B is 10 degrees or less.

The imprint mold 20 is manufactured using the stacked body 10 described above. Therefore, the substrate 1 in the imprint mold 20 is a glass substrate including at least one of CaO, La₂O₃, Nb₂O₅, and BaO. The functional layers 2a, 2b, and 2c constituting the predetermined mold pattern are made of a material etchable with the above-mentioned fluorine-containing gas. The functional layers 2a, 2b, and 2c may also be made of a material etchable with the chlorine-containing gas.

In the imprint mold 20, the functional layers 2a, 2b, and 2c are in contact with the substrate 1.

In the imprint mold 20, a transmittance of light having a wavelength of 365 nm in the state where the substrate 1 and the functional layers 2a, 2b, and 2c are stacked is preferably 50% or more.

In the imprint mold 20, width dimensions of the recesses 5 are, for example, preferably 10 µm or less, more preferably 1 µm or less, and further preferably 0.8 µm. The width dimensions of the recesses 5 may be, for example, 3 nm or more, 10 nm or more, 100 nm or more.

In the imprint mold 20, recesses may be formed on a back surface of the substrate 1. Here, the back surface refers to a main surface of the substrate 1 which faces away from the main surface on which the functional layers 2a, 2b, and 2c are formed. Since the recesses are formed on the back surface of the substrate 1, the imprint mold 20 can be easily peeled from a transfer target after the mold pattern is transferred to the transfer target by imprinting, which is preferable.

### [Method for Manufacturing Imprint Mold]

Next, a method for manufacturing the imprint mold according to the present invention will be described.

The imprint mold manufacturing method according to the present invention includes the steps of: preparing the stacked body 10 mentioned above; forming an etching mask pattern on the etching mask layer 3 of the stacked body 10; etching the functional layer 2 of the stacked body 10 using the etching mask pattern as a mask; and removing the etching mask pattern.

Now, a specific embodiment of the imprint mold manufacturing method according to the present invention will be described with reference to the drawings.

### <First Embodiment>

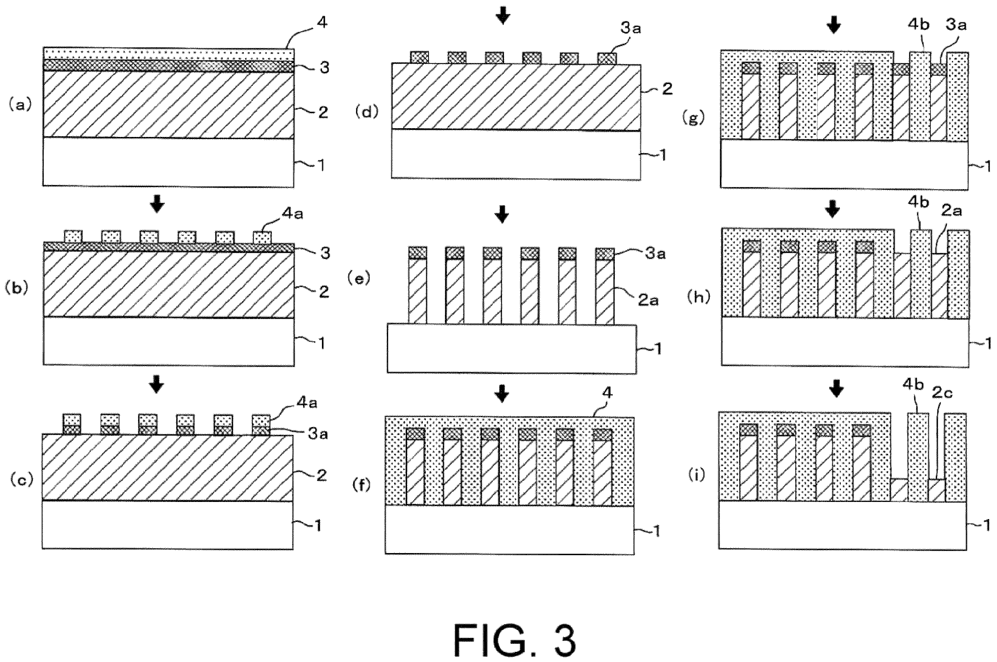

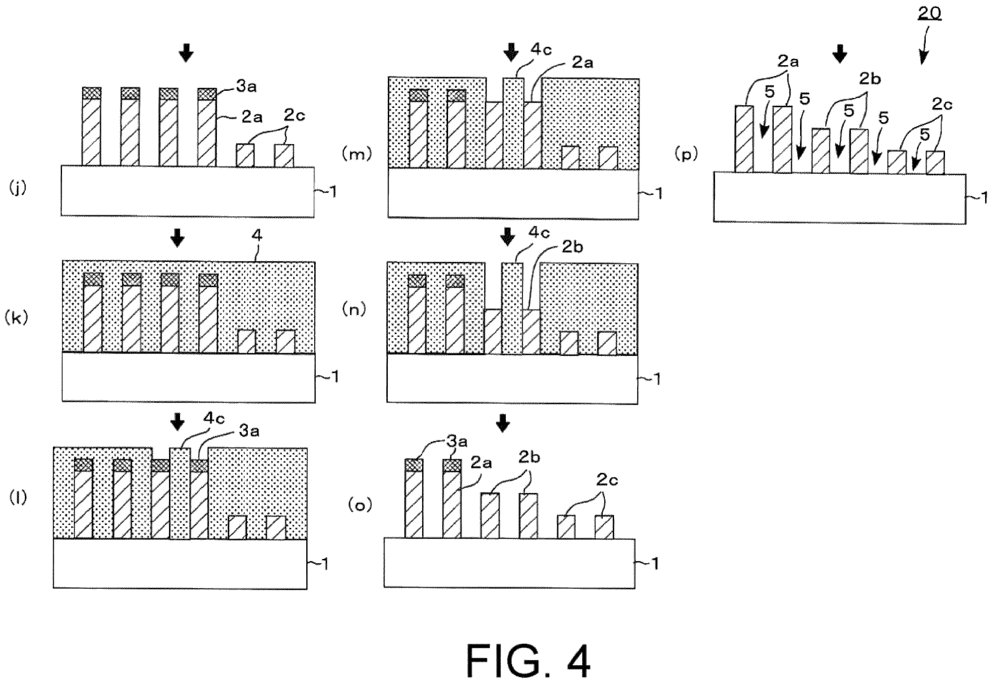

FIGS. 3(a) to 3(i) are cross-sectional views for explaining an imprint mold manufacturing process according to a first embodiment, and FIGS. 4(j) to 4(p) are cross-sectional views showing a continuation of the manufacturing process in FIG. 3.

On an upper surface of the stacked body 10 according to the one embodiment of the present invention, a resist film 4, for example, made of a liquidstate photocurable resin, is applied (see FIG. 3(a)). The resist film 4 in this case is preferably a negative resist, but a positive resist may be used.

Next, a fine pattern (mold pattern) is drawn on the resist film 4 with laser and, after the drawing, the resist film is developed to form a resist pattern 4a (see FIG. 3(b)).

Next, the stacked body 10 formed with the resist pattern 4a is introduced into a dry etching apparatus. By dry etching using the etching gas (for example, a chlorine-based gas, Cl₂ or the like), the etching mask layer 3 is etched using the resist pattern 4a as a mask to form an etching mask pattern 3a as shown in FIG. 3(c).

Here, the stacked body formed with the etching mask pattern 3a is taken out from the dry etching apparatus and the remaining resist pattern 4a is removed (see FIG. 3(d)). Here, a next step may be performed without removing the remaining resist pattern 4a. For convenience of explanation, the stacked body 10 formed with the etching mask pattern 3a and so on may also be referred to as the "stacked body."

Next, by performing dry etching in the same dry etching apparatus using, for example, a fluorine-based gas (CHF₃, CF₄, or the like), the functional layer 2 is etched using the etching mask pattern 3a as a mask until the main surface of the substrate 1 is exposed, thereby forming the recesses. As shown in FIG. 3(e), a functional layer pattern 2a having a concave-convex structure is formed on the substrate 1.

In the present invention, the amount of processing damage of the substrate 1 due to etching can be negligibly small at the bottom of each recess where the main surface of the substrate 1 is exposed. As a result, the recesses obtained by digging the functional layer 2 by etching can accurately be formed into a desired shape.

Here, when the remaining etching mask pattern 3a is peeled off, the imprint mold with the functional layer pattern 2a having a plurality of protrusions of the same height is completed.

Next, the resist film 4 is again applied to the upper surface of the stacked body formed with the etching mask pattern 3a and the functional layer pattern 2a (see FIG. 3(f)). Note that the resist film 4 in this case is preferably a positive resist so that a drawing region in a subsequent step can be reduced. In the following, a case where the positive resist is used will be described. Needless to say, a negative resist may be used.

Next, a drawing with laser is performed in a predetermined region (in the first embodiment, a region where a functional layer pattern 2c, described later, is to be formed) on the resist film 4. After the drawing, the resist film is developed to form a resist pattern 4b (see FIG. 3(g)). The substrate 1 has high resistance to the fluorine-containing gas and the chlorine-containing gas. When the functional layer pattern 2a is etched in the step of FIG. 3(i), no or negligibly small damage occurs in the substrate 1. Therefore, it is unnecessary to perform drawing in which the predetermined region completely matches with a first region where the functional layer pattern 2a, to be etched in the step of FIG. 3(i), is present. Therefore, as long as the predetermined region includes the first region, the drawing may be performed in which the predetermined region is larger than the first region. Thus, according to the first embodiment, it is unnecessary to precisely control an alignment between the first drawing (FIG. 3(b)) and the second drawing (FIG. 3(g)).

Next, the stacked body formed with the resist pattern 4b is introduced into the dry etching apparatus and, by dry etching using an etching gas (for example, a chlorine-based gas, Cl₂, or the like), the exposed etching mask pattern 3a is removed (see FIG. 3(h)).

Next, by dry etching using, for example, a fluorine-based gas (CHF₃, CF₄, or the like), the exposed functional layer pattern 2a is dug to a predetermined height (depth) to form the functional layer pattern 2c (see FIG. 3(i)).

Next, after the remaining resist pattern 4b is peeled off (see FIG. 4(j)), the resist film 4 is again applied to the upper surface of the stacked body (see FIG. 4(k)). Also for the resist film 4 in this case, a positive resist is preferable so that a drawing region in a subsequent step can be reduced. In the following, a case where the positive resist is used will be described. Needless to say, a negative resist may be used.

Next, a drawing with laser is performed in a predetermined region (in the first embodiment, a region where a functional layer pattern 2b (FIG. 4(n)), described later, is to be formed) is drawn on the resist film 4. After the drawing, the resist film is developed to form a resist pattern 4c (see FIG. 4(l)). Also herein, it is not necessary to precisely control an alignment between the first drawing, the second drawing (FIGS. 3(b), (g)) and the third drawing (FIG. 4(l)) as described above.

Next, the stacked body formed with the resist pattern 4c is introduced into the dry etching apparatus and, by dry etching using the etching gas (for example, a chlorine-based gas, Cl₂, or the like), the exposed etching mask pattern 3a is removed (see FIG. 4(m)).

Next, by dry etching using, for example, a fluorine-based gas (CHF₃, CF₄, or the like), the exposed functional layer pattern 2a is dug to a predetermined height (depth) to form the functional layer pattern 2b (see FIG. 4(n)).

Next, after the remaining resist pattern 4c is peeled off (see FIG. 4(o)), the etching mask pattern 3a remaining on the functional layer pattern 2a is removed to complete the imprint mold 20 including the substrate 1 and the functional layers 2a, 2b, and 2c formed on the substrate 1 and having a concave-convex structure with different heights constituting a predetermined mold pattern, as illustrated in FIG. 4(p).

### <Second Embodiment>

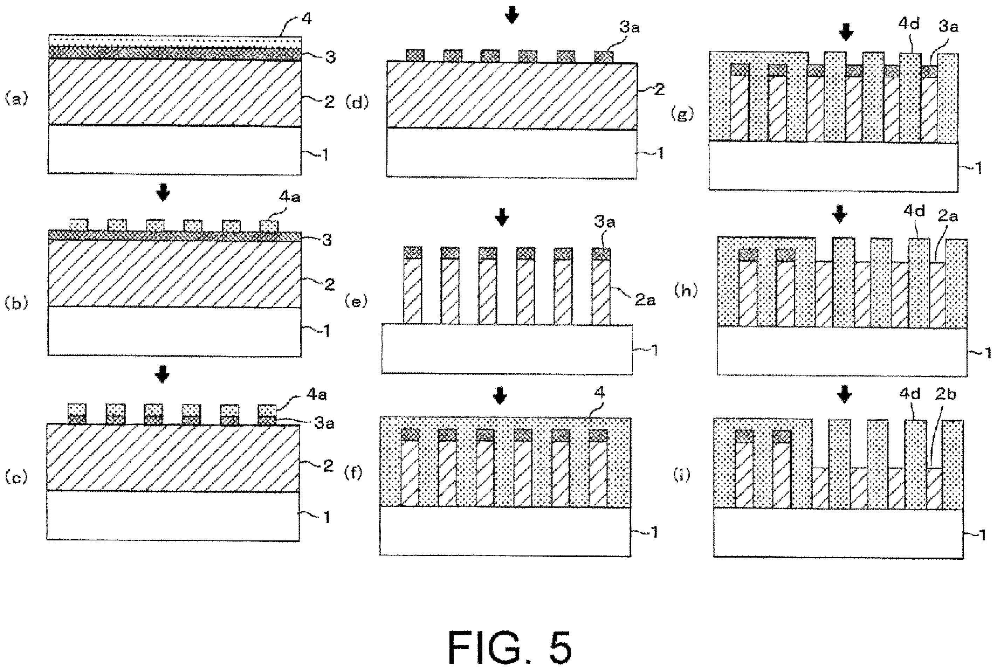

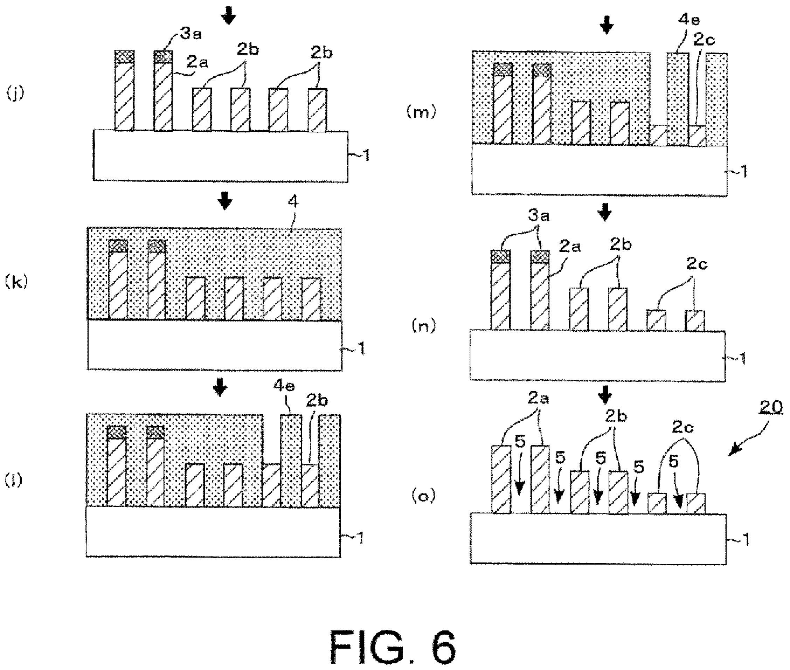

FIGS. 5(a) to 5(i) are cross-sectional views for explaining an imprint mold manufacturing process according to a second embodiment, and FIGS. 6(j) to 6(o) are cross-sectional views showing a continuation of the manufacturing process in FIG. 5.

On the upper surface of the stacked body 10 according to the one embodiment of the present invention, the resist film 4 is applied (see FIG. 5(a)). The resist film 4 in this case is preferably a negative resist, but a positive resist may be used.

Next, the fine pattern (mold pattern) is drawn on the resist film 4 with laser. After the drawing, the resist film is developed to form the resist pattern 4a (see FIG. 5(b)).

Next, the stacked body formed with the resist pattern 4a is introduced into the dry etching apparatus. By dry etching using the etching gas (for example, a chlorine-based gas, Cl₂, or the like), the etching mask layer 3 is etched using the resist pattern 4a as a mask to form the etching mask pattern 3a as shown in FIG. 5(c).

Here, the stacked body formed with the etching mask pattern 3a is taken out from the dry etching apparatus and the remaining resist pattern 4a is removed (see FIG. 5(d)). Here, a next step may be performed without removing the remaining resist pattern 4a.

Next, by performing dry etching in the same dry etching apparatus using, for example, the fluorine-based gas (CHF₃, CF₄, or the like), the functional layer 2 is etched using the etching mask pattern 3a as a mask until the main surface of the substrate 1 is exposed, thereby forming the recesses. As shown in FIG. 5(e), the functional layer pattern 2a having the concave-convex structure is formed on the substrate 1.

As described above, in the present invention, the amount of processing damage of the substrate 1 due to etching can be negligibly small at the bottom of each recess where the main surface of the substrate 1 is exposed. As a result, the recess obtained by digging the functional layer 2 by etching can accurately be formed into a desired shape.

Here, when the remaining etching mask pattern 3a is peeled off, the imprint mold with the functional layer pattern 2a having a plurality of protrusions of the same height is completed.

Next, the resist film 4 is again applied to the upper surface of the stacked body formed with the etching mask pattern 3a and the functional layer pattern 2a (see FIG. 5(f)). Note that the resist film 4 in this case is preferably a positive resist so that a drawing region in a subsequent step can be reduced. In the following, a case where the positive resist is used will be described. Needless to say, a negative resist may be used.

Next, a drawing with laser is performed in a predetermined region (in the second embodiment, a region where the functional layer patterns 2b and 2c, described later, are to be formed) on the resist film 4. After the drawing, the resist film is developed to form a resist pattern 4d (see FIG. 5(g)). Also herein, it is unnecessary to precisely control an alignment between the first drawing (FIG. 5(b)) and the second drawing (FIG. 5(g)), as described above.

Next, the stacked body formed with the resist pattern 4d is introduced into the dry etching apparatus and, by dry etching using the etching gas (for example, a chlorine-based gas, Cl₂, or the like), the exposed etching mask pattern 3a is removed (see FIG. 5(h)).

Next, by dry etching using, for example, a fluorine-based gas (CHF₃, CF₄, or the like), the exposed functional layer pattern 2a is dug to a predetermined height (depth) to form the functional layer pattern 2b (see FIG. 5(i)).

Next, after the remaining resist pattern 4d is peeled off (see FIG. 6(j)), the resist film 4 is again applied to the upper surface of the stacked body (see FIG. 6(k)). Also for the resist film 4 in this case, a positive resist is preferable so that a drawing region in a subsequent step can be reduced. In the following, a case where the positive resist is used will be described. Needless to say, a negative resist may be used.

Next, a drawing with laser is performed in a predetermined region (in the second embodiment, a region where the functional layer pattern 2c, described later, is to be formed) on the resist film 4. After the drawing, the resist film is developed to form a resist pattern 4e (see FIG. 6(l)). Also herein, it is not necessary to precisely control an alignment between the two drawings as described above.

Next, the stacked body formed with the resist pattern 4e is introduced into the dry etching apparatus and, by dry etching using, for example, a fluorine-based gas (CHF₃, CF₄, or the like), the exposed functional layer pattern 2b is dug to a predetermined height (depth) to form the functional layer pattern 2c (see FIG. 6(m)).

Next, after the remaining resist pattern 4e is peeled off (see FIG. 6(n)), the etching mask pattern 3a remaining on the functional layer pattern 2a is removed to complete the imprint mold 20 including the substrate 1 and the functional layers 2a, 2b, and 2c formed on the substrate 1 and having a concave-convex structure with different heights constituting a predetermined mold pattern, as illustrated in FIG. 6(o).

### <Third Embodiment>

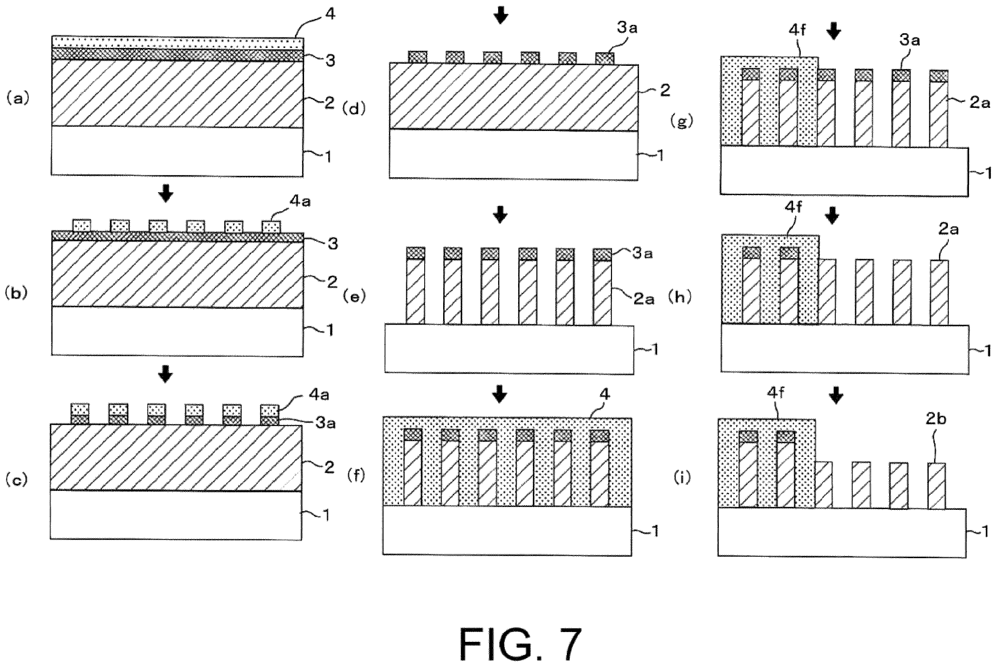

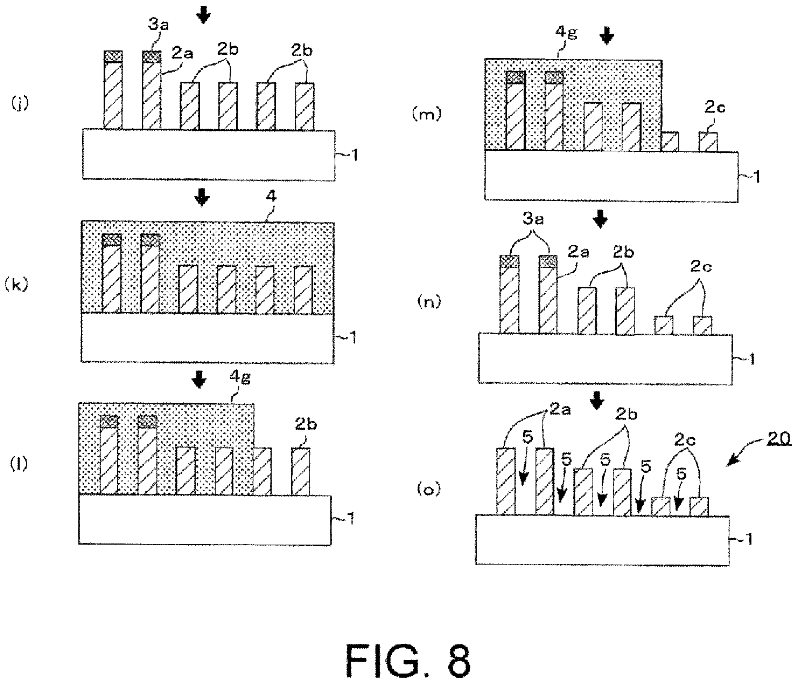

FIGS. 7(a) to 7(i) are cross-sectional views for explaining an imprint mold manufacturing process according to a third embodiment, and FIGS. 8(j) to 8(o) are cross-sectional views showing a continuation of the manufacturing process in FIG. 7.

On the upper surface of the stacked body 10 according to the one embodiment of the present invention, the resist film 4 is applied (see FIG. 7(a)). The resist film 4 in this case is preferably a negative resist, but a positive resist may be used.

Next, the fine pattern (mold pattern) is drawn on the resist film 4 with laser and, after the drawing, the resist film is developed to form the resist pattern 4a (see FIG. 7(b)).

Next, the stacked body formed with the resist pattern 4a is introduced into the dry etching apparatus. By dry etching using the etching gas (for example, a chlorine-based gas, Cl₂, or the like), the etching mask layer 3 is etched using the resist pattern 4a as a mask to form the etching mask pattern 3a as shown in FIG. 7(c).

Here, the stacked body formed with the etching mask pattern 3a is taken out from the dry etching apparatus and the remaining resist pattern 4a is removed (see FIG. 7(d)). Here, a next step may be performed without removing the remaining resist pattern 4a.

Next, by performing dry etching in the same dry etching apparatus using, for example, the fluorine-based gas (CHF₃, CF₄, or the like), the functional layer 2 is etched using the etching mask pattern 3a as a mask until the main surface of the substrate 1 is exposed, thereby forming the recesses. As shown in FIG. 7(e), the functional layer pattern 2a having the concave-convex structure is formed on the substrate 1.

As described above, in the present invention, the amount of processing damage of the substrate 1 due to etching can be negligibly small at the bottom of each recess where the main surface of the substrate 1 is exposed. As a result, the recess obtained by digging the functional layer 2 by etching can accurately be formed into a desired shape.

Here, when the remaining etching mask pattern 3a is peeled off, the imprint mold with the functional layer pattern 2a having a plurality of protrusions of the same height is completed.

Next, the resist film 4 is again applied to the upper surface of the stacked body formed with the etching mask pattern 3a and the functional layer pattern 2a (see FIG. 7(f)). Note that the resist film 4 in this case is preferably a positive resist so that a drawing region in a subsequent step can be reduced. In the following, a case where the positive resist is used will be described. Needless to say, a negative resist may be used.

Next, a drawing with laser is performed in a predetermined region (in the third embodiment, a region including a region where the functional layer patterns 2b and 2c, described later, are to be formed) on the resist film 4. After the drawing, the resist film is developed to form a resist pattern 4f (see FIG. 7(g)). Also herein, it is unnecessary to precisely control an alignment between the two drawings.

Next, the stacked body formed with the resist pattern 4f is introduced into the dry etching apparatus and, by dry etching using the etching gas (for example, a chlorine-based gas, Cl₂, or the like), the exposed etching mask pattern 3a is removed (see FIG. 7(h)).

Next, by dry etching using, for example, a fluorine-based gas (CHF₃, CF₄, or the like), the exposed functional layer pattern 2a is dug to a predetermined height (depth) to form the functional layer pattern 2b (see FIG. 7(i)).

Next, after the remaining resist pattern 4f is peeled off (see FIG. 8(j)), the resist film 4 is again applied to the upper surface of the stacked body (see FIG. 8(k)). Also for the resist film 4 in this case, a positive resist is preferable so that a drawing region in a subsequent step can be reduced. In the following, a case where the positive resist is used will be described. Needless to say, a negative resist may be used.

Next, a drawing with laser is performed in a predetermined region (in the third embodiment, a region including a region where the functional layer pattern 2c, described later, is to be formed) on the resist film 4. After the drawing, the resist film is developed to form a resist pattern 4g (see FIG. 8(l)). Also herein, it is not necessary to precisely control an alignment between the two drawings as described above.

Next, the stacked body formed with the resist pattern 4g is introduced into the dry etching apparatus and, by dry etching using, for example, a fluorine-based gas (CHF₃, CF₄, or the like), the exposed functional layer pattern 2b is dug to a predetermined height (depth) to form the functional layer pattern 2c (see FIG. 8(m)).

Next, after the remaining resist pattern 4g is peeled off (see FIG. 8(n)), the etching mask pattern 3a remaining on the functional layer pattern 2a is removed to complete the imprint mold 20 including the substrate 1 and the functional layers 2a, 2b, and 2c formed on the substrate 1 and having a concave-convex structure with different heights constituting a predetermined mold pattern, as illustrated in FIG. 8(o).

### [Method for Manufacturing Optical Element, Method for Manufacturing Electronic Component]

The present invention also provides a method for manufacturing an optical element and a method for manufacturing an electronic component. Specifically, the optical element manufacturing method according to the present invention includes the steps of: preparing an imprint mold manufactured using the above-mentioned stacked body of the present invention or preparing the above-mentioned imprint mold of the present invention; curing a resin (transfer target) applied to an optical element substrate in a state where the imprint mold is pressed against the resin; and separating the imprint mold from the resin.

The electronic component manufacturing method according to the present invention includes the steps of: preparing an imprint mold manufactured using the above-mentioned stacked body of the present invention or preparing the above-mentioned imprint mold of the present invention: curing a resin (transfer target) applied to an electronic component substrate in a state where the imprint mold is pressed against the resin; and separating the imprint mold from the resin.

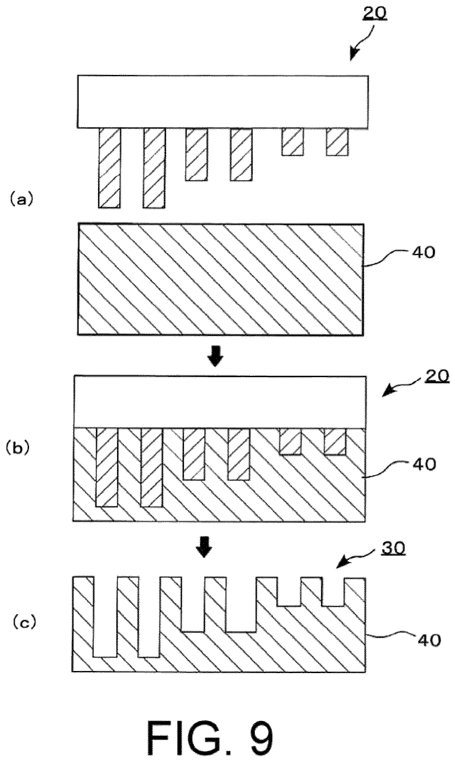

FIG. 9 shows cross-sectional views for explaining pattern transfer to a transfer target by imprinting. The above-mentioned imprint mold (master mold) 20 obtained by the present invention is directly pressed against a resin (for example, a photocurable resin or a thermosetting resin) 40 as a transfer object (transfer target), and the resin 40 is cured in a state where the imprint mold 20 is pressed against the resin 40 (see FIG. 9(a), FIG. 9(b)). When the photocurable resin is used, light irradiation may be performed either from an imprint mold side or a resin side.

The resin 40 may be applied onto another substrate, for example, a transfer object constituting layer (for example, an optical element substrate or an electronic component substrate (e.g. a silicon wafer)). The resin 40 may be applied onto the imprint mold 20.

Next, by separating (releasing) the imprint mold 20 from the resin 40, obtained is a transfer object 30 with the mold pattern of the imprint mold 20 transferred thereon, as illustrated in FIG. 9(c).

By transferring the mold pattern of the imprint mold 20 to the resin 40, a replica mold may be manufactured from the master mold.

By using the imprint mold 20 obtained by the present invention, a mold pattern with high accuracy can accurately be transferred to the transfer target. Therefore, it is possible to manufacture an optical element or an electronic component having a fine pattern with high accuracy.

As described above, according to the present invention, it is possible to provide a stacked body suitably usable as an imprint mold blank capable of obtaining a desired concave-convex shape with high accuracy, without complicating a design process and a manufacturing process.

Furthermore, according to the present invention, it is possible to provide an imprint mold manufactured using the above-mentioned stacked body and having a mold pattern with high accuracy, and a method for manufacturing the imprint mold.

Furthermore, according to the present invention, it is possible to provide a method for manufacturing an optical element and a method for manufacturing an electronic component, each of the optical element and the electronic component, having a fine pattern with high accuracy, formed by using the above-mentioned imprint mold.

### EXAMPLES

In the following, the embodiments of the present invention will be described further in detail with reference to examples.

### (Example 1)

### [Fabrication of Stacked body]

A substrate made of glass with a main surface having a dimension of about 152 mm × about 152 mm and a thickness of about 6.25 mm was prepared. The substrate used in Example 1 is a substrate containing at least one of CaO, La₂O₃, Nb₂O₅, and BaO. Details of its composition are shown in Table 1 below.

First, a functional layer consisting of silicon and oxygen (SiO₂ layer Si : O = 34 atomic% : 66 atomic%) was formed on the substrate to a thickness of 100 nm. The functional layer was formed by placing the substrate in a single-wafer RF sputtering apparatus and by performing reactive sputtering with an RF power supply (RF sputtering) using a SiO₂ target and argon (Ar) gas as a sputtering gas.

Next, an etching mask layer consisting of chromium and nitrogen (CrN layer Cr : N = 75 atomic% : 25 atomic%) was formed on the functional layer to a thickness of 50 nm. The etching mask layer was formed by placing the substrate with the functional layer formed thereon in a single-wafer DC sputtering apparatus and by performing reactive sputtering with a DC power supply (DC sputtering) using a chromium (Cr) target and a mixed gas of argon (Ar), helium (He) and nitrogen (N₂) as a sputtering gas.

As described above, a stacked body of Example 1, obtained by forming the functional layer and the etching mask layer on the substrate, was fabricated.

### [Fabrication of Imprint Mold]

On an upper surface of the stacked body of the Example 1, a negative resist film of a liquid photocurable resin was applied. Next, a predetermined fine pattern (mold pattern) was drawn on the resist film with laser and, after the drawing, the resist film was developed to form a resist pattern.

Next, the stacked body formed with the resist pattern was introduced into a dry etching apparatus. By dry etching using a chlorine-based gas (a mixed gas of chlorine gas (Cl₂) and oxygen gas (O₂)), the etching mask layer was etched using the resist pattern as a mask to form an etching mask pattern.

Here, the stacked body formed with the etching mask pattern was taken out from the dry etching apparatus and the remaining resist pattern was removed.

Next, by dry etching in the same dry etching apparatus using a mixed gas containing CHF₃ and CF₄ (CHF₃: CF₄ = 1 : 2.5 in a flow rate ratio), the functional layer was etched using the etching mask pattern as a mask until the main surface of the substrate was exposed, thereby forming recesses. As shown in FIG. 3(e) mentioned above, a functional layer pattern having a concave-convex structure was formed on the substrate. Here, ICP (Inductively Coupled Plasma) etching was used. As an etching condition at this time, ICP power as plasma excitation power was 425 W, RF power (bias power) was 125 W, and a pressure was 5 mTorr.

Further, the remaining etching mask pattern was peeled off. Thus, an imprint mold with the functional layer pattern having a plurality of protrusions of the same height on the substrate was fabricated.

### (Examples 2 to 9)

In the same manner as in the Example 1 except that substrates having glass compositions of Examples 2 to 9 shown in Table 1 below were used, respectively, stacked bodies of Examples 2 to 9 were fabricated by forming the functional layers and the etching mask layers on the substrates.

Next, by using the stacked bodies of Examples 2 to 9 and etching the functional layers by the same method and under the same etching condition as in the Example 1 until the main surfaces of the substrates were exposed, thereby forming recesses. Thus, imprint molds of Examples 2 to 9 with the functional layer pattern having a plurality of protrusions of the same height on the substrates were fabricated.

### (Comparative Example)

In the same manner as in the Example 1 except that a synthetic quartz substrate (SiO₂) of Comparative Example shown in Table 1 below was used, a stacked body of Comparative Example having the substrate with the functional layer and the etching mask layer formed thereon was fabricated.

Next, by using the stacked body of Comparative Example and etching the functional layer by the same method and under the same etching condition as in the Example 1 until the main surface of the substrate was exposed, thereby forming recesses. Thus, an imprint mold of Comparative Example with the functional layer pattern having a plurality of protrusions of the same height on the substrate was fabricated.

**[Table 1]**

| | CaO, La₂O₃, Nb₂O₄, Bao Total Content (mass%) | SiO₂ | B₂O₃ | P₂O₅ | Al₂O₃ | Li₂O | Na₂O | K₂O | CaO | BaO | ZnO | La₂O₃ |
|---|---|---|---|---|---|---|---|---|---|---|---|---|
| Example 1 | 48 | 30 | 2 | 0 | 0 | 1 | 0 | 0 | 26 | 0 | 0 | 3 |
| Example 2 | 57.53 | 6.92 | 13.66 | 0 | 0 | 0 | 0 | 0 | 3.25 | 10.51 | 2.83 | 38.18 |
| Example 3 | 62.5 | 0 | 3 | 19.5 | 0 | 0 | 3 | 4 | 1 | 16 | 0 | 0 |
| Example 4 | 57 | 6 | 8 | 0 | 0 | 0 | 0 | 0 | 0 | 15 | 2 | 34 |
| Example 5 | 57.34 | 4.72 | 9.21 | 0 | 0 | 0 | 0 | 0 | 0 | 0 | 1.4 | 49.4 |
| Example 6 | 31 | 24.9 | 0 | 0 | 0 | 0 | 12.5 | 0 | 0.8 | 16.1 | 0 | 0 |
| Example 7 | 31.8 | 0 | 0 | 26.8 | 0 | 0.1 | 0 | 4 | 0 | 0 | 0 | 0 |
| Example 8 | 48 | 4.5 | 88 | 21.4 | 2 | 0.5 | 6 | 8.8 | 0 | 0 | 0 | 0 |
| Example 9 | 37.14 | 0 | 2.54 | 25.87 | 0 | 4.36 | 5.88 | 1.38 | 0 | 2.24 | 1.19 | 0 |
| Comparative Example | 0 | 100 | 0 | 0 | 0 | 0 | 0 | 0 | 0 | 0 | 0 | 0 |

| | Gd₂O₃ | Y₂O₃ | ZrO₂ | TiO₂ | Nb₂O₅ | WO₃ | Bi₂O₃ | Sb₂O₃ | Total (mass%) | Refractive Index nd | Abbe Number v_{d} |
|---|---|---|---|---|---|---|---|---|---|---|---|
| Example 1 | 0 | 0 | 10 | 9 | 19 | 0 | 0 | 0 | 100 | 1.807 | 33 |
| Example 2 | 0 | 0 | 5.94 | 13.12 | 5.59 | 0 | 0 | 0 | 100 | 1.90059 | 31.39 |
| Example 3 | 0 | 0 | 0 | 8 | 45.5 | 0 | 0 | 0 | 100 | 1.9186 | 20.5 |
| Example 4 | 0 | 0 | 6.5 | 20.5 | 8 | 0 | 0 | 0 | 100 | 2.0003 | 25.51 |
| Example 5 | 7.58 | 0.56 | 5.84 | 13.35 | 7.94 | 0 | 0 | 0 | 100 | 2.00165 | 29.05 |
| Example 6 | 0 | 0 | 1.98 | 29.6 | 14.1 | 0 | 0 | 0.02 | 100 | 1.84711 | 23.76 |
| Example 7 | 0 | 0 | 0 | 26 | 31.8 | 11.3 | 0 | 0 | 100 | 1.98742 | 16.45 |
| Example 8 | 0 | 0 | 0 | 0 | 48 | 0 | 0 | 0 | 100 | 1.75431 | 25.1 |
| Example 9 | 0 | 0 | 0 | 2.92 | 34.9 | 8.46 | 10.26 | 0 | 100 | 1.82485 | 24.02 |
| Comparative Example | 0 | 0 | 0 | 0 | 0 | 0 | 0 | 0 | 100 | 1.45848 | 67.9 |

### <Evaluation>

In the recesses of each imprint mold of Examples 1 to 9 and Comparative Example thus obtained, the amount of processing damage of the substrate was measured. The result is as follows.

### Example 1: 69.7 nm, Example 2: 90 nm, Example 3: 97 nm, Example 4: 145 nm, Example 5: 202 nm, Example 6: 269 nm, Example 7: 662 nm, Example 8: 663.1 nm, Example 9: 674 nm

### Comparative Example: 2452 nm

As is clear from the result mentioned above, in each example, the amount of processing damage of the substrate could significantly be reduced to less than 30% of the amount of processing damage of the synthetic quartz substrate (SiO₂) of Comparative Example. In Examples of the present invention, the amount of processing damage of the substrate due to the etching of the functional layer could be negligibly reduced at the bottom of each recess where the main surface of the substrate was exposed. As a result, the recesses obtained by digging the functional layer by etching could accurately be formed into a desired shape. Note that an etching selectivity ratio of the functional layer with respect to the substrate in each of Examples was 2.5 or more. In contrast, in Comparative Example, the amount of processing damage of the substrate was large, and the recesses could not be formed into a desired shape. In Comparative Example, surface roughening of the bottom of the recesses occurred, and transmittance of light having a wavelength of 365 nm was significantly reduced also.

As another example, stacked bodies using SiON, Si₃N₄, and TiO₂ as the functional layers, respectively, were fabricated. In the same manner as mentioned above, the functional layers were etched to fabricate imprint molds. Then, similarly to the case where SiO₂ is used as the functional layer, damages of substrates in another example were negligibly small whereas a damage of the substrate in Comparative Example was large. Etching selectivity ratio of each functional layer with respect to the substrate in another example was 2.5 or more.

By using each of the imprint molds obtained in Examples 1 to 9 as a master mold, photoimprint lithography was performed to fabricate a replica mold (see FIG. 9 mentioned above). Then, the replica mold having a desired shape with high accuracy was obtained. On the other hand, by using the imprint mold of Comparative Example, a replica mold having a desired shape was not obtained.

As described above, according to Examples of the present invention, an imprint mold having a mold pattern of a desired shape with high accuracy can be obtained, without complicating a design process and a manufacturing process. Further, by using the imprint mold, a replica mold having a desired shape with high accuracy can be obtained. In addition, an optical element, an electronic component, and the like having a fine pattern with high accuracy can be fabricated.

### EXPLANATION OF REFERENCE NUMERALS

1 substrate
2 functional layer
2a, 2b, 2c functional layer (protrusion)
3 etching mask layer
4 resist film
5 recess
10 stacked body
20 imprint mold (master mold)
30 transfer object
40 resin (transfer target)

## Claims

1. A stacked body comprising:
a substrate containing at least one of CaO, La₂O₃, Nb₂O₅, and BaO,
a functional layer formed on the substrate, and
an etching mask layer formed on the functional layer.

2. The stacked body according to claim 1, wherein the functional layer is in contact with the substrate.

3. The stacked body according to claim 1, wherein a total content of CaO, La₂O₃, Nb₂O₅, and BaO contained in the substrate is 30 mass% or more.

4. The stacked body according to claim 1, wherein the functional layer is made of a material containing silicon and at least one of oxygen and nitrogen.

5. The stacked body according to claim 1, wherein, in a state where the functional layer is stacked on the substrate, a transmittance of light having a wavelength of 365 nm transmitted through the substrate and the functional layer is 50% or more.

6. The stacked body according to claim 1, wherein the etching mask layer contains one or more selected from chromium, tantalum, zirconium, hafnium, and tungsten.

7. A method for manufacturing an imprint mold, comprising the steps of:
preparing the stacked body according to any one of claims 1 to 6;
forming an etching mask pattern on the etching mask layer;
etching the functional layer using the etching mask pattern as a mask; and
removing the etching mask pattern.

8. An imprint mold comprising:
a substrate containing at least one of CaO, La₂O₃, Nb₂O₅ and BaO; and
a functional layer formed on the substrate,
wherein the functional layer has a plurality of recesses constituting a predetermined mold pattern.

9. The imprint mold according to the claim 8, wherein the functional layer is in contact with the substrate.

10. The imprint mold according to claim 8, wherein a total content of CaO, La₂O₃, Nb₂O₅, and BaO contained in the substrate is 30 mass% or more.

11. The imprint mold according to claim 8, wherein the functional layer is made of a material containing silicon and at least one of oxygen and nitrogen.

12. The imprint mold according to claim 8, wherein, in a state where the functional layer is stacked on the substrate, a transmittance of light having a wavelength of 365 nm transmitted through the substrate and the functional layer is 50% or more.

13. The imprint mold according to claim 8, wherein each recess has a bottom which is an exposed part of the substrate.

14. A method for manufacturing an optical element, comprising the steps of:
preparing an imprint mold manufactured using the stacked body according to any one of claims 1 to 6 or preparing the imprint mold according to any one of claims 8 to 13;
curing a transfer target applied to an optical element substrate in a state where the imprint mold is pressed against the transfer target; and
separating the imprint mold from the transfer target.

15. A method for manufacturing an electronic component, comprising the steps of:
preparing an imprint mold manufactured using the stacked body according to any of claims 1 to 6 or preparing the imprint mold according to any one of claims 8 to 13;
curing a transfer target applied to an electronic component substrate in a state where the imprint mold is pressed against the transfer target; and
separating the imprint mold from the transfer target.
